# EUROPÄISCHE PATENTSCHRIFT

(11) **EP 1 968 101 B1**
(45) Veröffentlichungstag und Bekanntmachung des Hinweises auf die Patenterteilung: **26.09.2012**
(21) Anmeldenummer: 08004150.2
(22) Anmeldetag: 06.03.2008
(51) Int. Cl.: H01L 35/30, H01J 61/52, H01K 1/58, F21S 8/00, H02N 11/00, B64F 1/20, F21V 29/02

(54) **Leuchte mit Einrichtung zur Kühlung der Lampe**
Lighting device with lamp cooling means
Système d'éclairage avec dispositif pour le refroidissement de la lampe

(30) Priorität: 06.03.2007 DE 102007011260
(43) Veröffentlichungstag der Anmeldung: 10.09.2008
(60) Teilanmeldung: 11002268.8
(73) Patentinhaber: Quinten, Werner, 66839 Schmelz (DE)
(72) Erfinder: Quinten, Werner, 66839 Schmelz (DE)
(74) Vertreter: Bernhardt, Reinhold

(56) Entgegenhaltungen:
- WO-A-99/50590
- DE-A1-102004 041 956
- DE-C- 707 528
- FR-A- 648 623
- FR-A- 904 049
- US-A- 2 105 430
- US-A- 2 275 739
- US-A- 3 567 917
- US-A- 3 869 605
- US-A- 4 877 991
- US-A1- 2002 145 875
- US-A1- 2005 000 559

## Beschreibung

Die Erfindung betrifft eine Leuchte mit einem Leuchtelement, das in einem Gehäuse angeordnet ist, welches einen Reflektor und ein Lichtaustrittsfenster umfasst, und mit Einrichtungen zur Abführung von Wärme von dem Leuchtelement, wobei das Leuchtelement in einer Hülle eingeschlossen ist, welche einen Einlass und einen Auslass für ein an einer Innenwandfläche der Hülle strömendes Kühlmittel aufweist, sowie eine Baueinheit für eine Leuchte.

Eine solche Leuchte geht aus der DE 707 528 C hervor, in der ein KFZ-Scheinwerfer beschrieben ist, dessen Glühlampe von einem Wärmeschutzfilter umgeben ist. Durch einen Raum zwischen dem Wärmeschutzfilter und einem den Wärmeschutzfilter becherartig umschließenden Gefäß wird Kühlluft geführt.

Weitere Leuchten mit einem Leuchtelement, zu dessen Kühlung ein in einer Hülle strömendes Kühlmittel verwendet wird, gehen aus der FR 648 623 A und der DE 10 2004 041 956 A1 hervor.

Aus der FR-PS 904 049 ist eine Leuchte mit einer Glühbirne als Leuchtelement bekannt. Der die Anschlusskontakte der Glühbirne aufweisende Hals der Birne ist durch eine abgedichtete Öffnung in der Gehäusewand hindurch geführt und das Gehäuse weist einen Einlass und einen Auslass für ein Wärme von der Glühbirne abführendes Kühlmittel auf.

Der Erfindung liegt die Aufgabe zugrunde, eine neue Leuchte der eingangs erwähnten Art zu schaffen, die gegenüber herkömmlichen solchen Leuchten einen geringeren Wartungs- und Montageaufwand erfordert.

Die diese Aufgabe lösende Leuchte nach der Erfindung ist dadurch gekennzeichnet, dass die Hülle ein Doppelrohr mit einer Außenröhre und einer Innenröhre umfasst, wobei die Innenröhre gegen das Leuchtelement anliegt und das Leuchtelement in der Innenröhre verschiebbar ist.

Das Leuchtelement lässt sich aus der Innenröhre heraus bzw. in diese hineinschieben. Bei einem Defekt des Leuchtelements lässt sich dieses daher leicht auswechseln.

Vorteilhaft bleibt die Durchströmung der Leuchte mit Kühlmittel auf die nähere Umgebung des Leuchtelements beschränkt. Die Leuchtkraft beeinträchtigende Ablagerungen am Reflektor werden vermieden. Die in der Umgebung des Leuchtelements konzentrierte Strömung entwickelt eine intensive, Ablagerungen am Leuchtelement bzw. der Hülle verhindernde Spülwirkung.

Zweckmäßig sind Leuchtelement und Hülle in einer Baueinheit zusammengefasst und ggf. einstückig miteinander verbunden. So lässt sich die Leuchte bequem montieren.

In einer bevorzugten Ausführungsform der Erfindung ist das Leuchtelement länglich und die Hülle umfasst eine das Leuchtmittel umgebende Röhre. Das Kühlmittel kann an einem Ende der Röhre in die Röhre ein- und am anderen Ende aus der Röhre ausströmen und dabei gleichmäßig Wärme von dem Leuchtmittel auf dessen gesamter Länge abführen.

In der bevorzugten Ausführungsform weist das Leuchtelement an entgegengesetzten Enden jeweils einen elektrischen Anschlusskontakt auf. Vorzugsweise sind die Anschlusskontakte des Leuchtelements gegen den durchströmten Innenraum der Hülle elektrisch isoliert. Somit ist ein auf Elektrolyse basierender Stromfluss durch das Kühlmedium hindurch ausgeschlossen.

Die Hülle kann aus Glas oder/und einem durchsichtigen Kunststoff bestehen.

Der Ein- und Auslass können im Innenraum des Gehäuses angeordnet und Verbindungsleitungen zu einem Einlass bzw. Auslass am Gehäuse vorgesehen sein.

Alternativ liegen der Einlass und der Auslass jeweils an einer Stirnseite der Hülle und, in Längsrichtung des Leuchtelements gesehen, innerhalb der Kontur einer Öffnung am Gehäuse.

Die Leuchte bzw. das Leuchtelement kann Bestandteil einer Beleuchtungsanlage sein, die in Strömungsverbindung mit einem Heizelement steht. Beispielsweise können die Leuchten einer Flughafenbeleuchtung in Verbindung mit Heizelementen für die Start- und Landebahn stehen, durch die die Bahn schnee- und eisfrei gehalten wird.

Das Heizelement kann zur Aufheizung eines Wärmespeichers dienen, wobei durch thermoelektrische Elemente eine Umwandlung der Wärmeenergie in elektrische Energie erfolgen kann.

Die Erfindung wird nachfolgend anhand von Ausführungsbeispielen und der beiliegenden, sich auf diese Ausführungsbeispiele beziehenden Zeichnungen näher erläutert. Es zeigen:
- Fig. 1: ein Leuchtelement mit einer Hülle in einem Längsschnitt,
- Fig. 2: eine Teildarstellung eines Leuchtelements mit einer Hülle in einem Längsschnitt,
- Fig. 3: eine Leuchte mit einem umhüllten Leuchtelement gemäß Fig. 1 bzw. Fig. 2,
- Fig. 4: die Leuchte von Fig. 3 in einer Seitenansicht,
- Fig. 5: eine Beleuchtungsanlage mit erfindungsgemäßen Leuchten, die in Strömungsverbindung mit einem Heizelement stehen,
- Fig. 6: eine Anlage zur Rückgewinnung elektrischer Energie aus Wärme, die von Leuchten nach der Erfindung abgeführt worden ist, und
- Fig. 7: ein Leuchtelement mit einer Hülle gemäß vorliegender Erfindung.

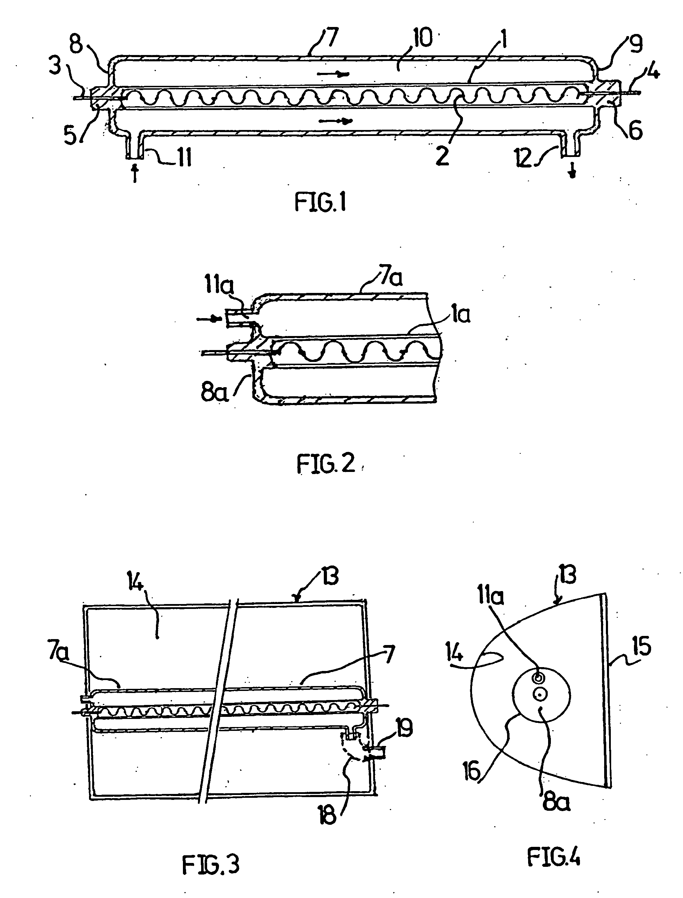

Bei den mit Bezugnahme auf die Fig. 1 bis 4 beschriebenen Beispielen handelt es sich nicht um Ausführungsformen der Erfindung, sondern um Beispiele, die das Verständnis der Erfindung erleichtern.

Ein in Fig. 1 gezeigtes Leuchtelement weist eine erste Glasröhre 1 auf, in der ein gewendelter Glühdraht 2 angeordnet ist. Die beiden Enden des Glühdrahts 2 sind jeweils mit einem Anschlusskontaktstift 3 bzw. 4 verbunden, welcher in einen die Glasröhre 1 endseitig verschließenden Glasblock 5 bzw. 6 eingeschmolzen ist.

Die erste Glasröhre 1 umgibt eine zweite, zu der ersten Glasröhre koaxiale Glasröhre 7 mit Stirnwänden 8 und 9, die einstückig mit der ersten Glasröhre 1 bzw. den Glasblöcken 5 und 6 verbunden sind. Ein zwischen der ersten und zweiten Glasröhre gebildeter Raum 10 weist einen Einlass 11 und einen Auslass 12 jeweils in Form eines Anschlussstutzens auf.

Während bei dem Beispiel von Fig. 1 die Ein- und Auslassöffnung in der Röhrenwand vorgesehen und die Anschlussstutzen senkrecht zur Längsachse der Glasröhren verlaufen, weist ein in Fig. 2 gezeigtes Leuchtelement mit einer ersten Glasröhre 1 a und einer zweiten Glasröhre 7a an den Stirnseiten einen Einlass bzw. Auslass auf. In Fig. 2 ist der Einlass 11a an der Stirnseite 8a gezeigt.

Fig. 3 zeigt Beispiele für Leuchten, wobei auf der linken Seite von Fig. 3 eine Leuchte mit der in Fig. 1 gezeigten Anordnung aus Leuchtelement und Hülle und auf der rechten Seite von Fig. 3 eine Leuchte mit dem in Fig. 2 gezeigten umhüllten Leuchtelement dargestellt ist.

Dementsprechend ist in der Seitenansicht von Fig. 4 der Einlass 11a an der Stirnseite 8a der Hülle sichtbar, und das Gehäuse 14 weist entsprechend große Öffnungen 16 an den Seiten auf, durch die hindurch sich das Leuchtelement sowohl elektrisch als auch an einen Kühlmittelkreislauf anzuschließen lässt.

Bei Verwendung des Leuchtelements von Fig. 1 sind kleinere Öffnungen 17 in den Seitenwänden des Gehäuses 13 vorgesehen. Ein Schlauch 18 verbindet den Ein- bzw. Auslass des Leuchtelements mit einem Einlass bzw. Auslass am Gehäuse. In Fig. 3 ist ein Auslass 19 am Gehäuse 13 gezeigt.

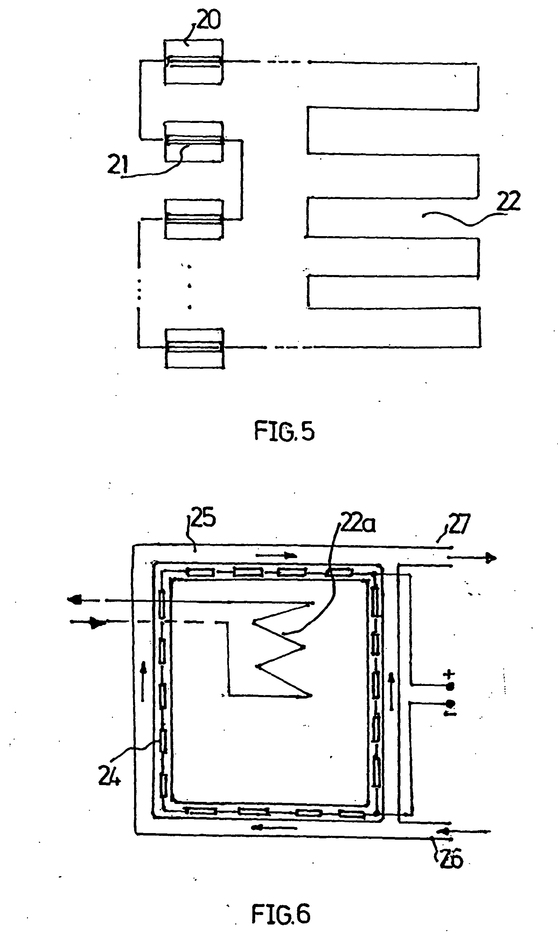

Fig. 5 zeigt schematisch eine Beleuchtungsanlage mit Leuchten 20 nach Fig. 3 oder 4. Die mit einem Kühlmittel, z.B. Wasser, durchströmbaren Innenräume der Leuchtelemente 21 der Leuchten 20 sind in einer Reihenanordnung miteinander verbunden und stehen in Verbindung mit einem Heizelement 22 in Form einer Kühlschlange. Das Heizelement 22 kann z.B. in der Start- und Landebahn eines Flugplatzes eingebettet sein. Als Wärmelieferanten ließen sich sämtliche Leuchten der Beleuchtungsanlage des Flugplatzes einbeziehen.

Es versteht sich, dass Reihen- und Parallelschaltungen der Leuchten miteinander kombiniert werden können.

Ferner könnten Zwischenspeicher, z.B. mit einer Wasserfüllung, zur Aufnahme von Wärme vorgesehen sein.

Gemäß Fig. 6 kann ein dem Heizelement 22 entsprechendes Heizelement 22a Wasser in einem Heißwasserspeicher 23 aufheizen. Der Heißwasserspeicher 23 ist von einer Anordnung parallel und in Reihe geschalteter thermoelektrischer Elemente 24 umgeben, welche einerseits der hohen Temperatur des Heißwasserspeichers 23 und andererseits der niedrigen Temperatur eines Wasserkreislaufs 25 mit einem Zulauf 26 und einem Ablauf 27 ausgesetzt sind. An den Thermoelementen lässt sich bei 28 elektrische Energie abgreifen.

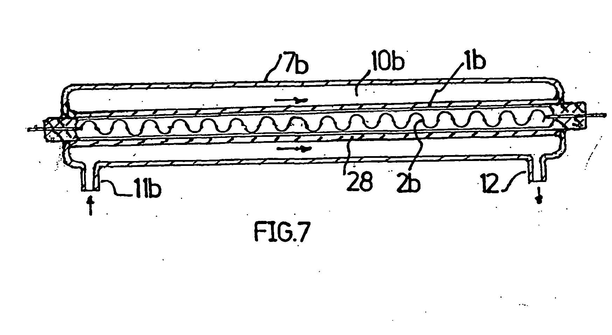

Fig. 7 zeigt eine erfindungsgemäße Anordnung aus einem Leuchtelement 1b und einer Hülle. Die Hülle besteht aus einem Doppelrohr mit einer Außenröhre 7b und einer Innenröhre 28. Die Innenröhre liegt unmittelbar gegen das Leuchtelement 1b an, so dass der Wärmedurchgang vom Leuchtelement 1b in einen mit Kühlmittel durchströmbaren Raum 10b nicht behindert ist. Das Leuchtelement 1b lässt sich aus der innenröhre 28 heraus bzw. in diese hineinschieben. Bei einem Defekt des Leuchtelements lässt sich dieses daher leicht auswechseln.

## Patentansprüche

1. Baueinheit mit einem Leuchtelement (1b) und einer Hülle (7b) welche einen Einlass (11b) und einen Auslass (12) für ein an einer Innenwandfläche der Hülle (7b) strömendes Kühlmittel zur Abführung von wärme von dem Leuchtelement (1b) aufweist, wobei
die Hülle ein Doppelrohr mit einer Außenröhre (7b) und einer Innenröhre (28) umfasst und die Innenröhre (28) gegen das Leuchtelement (1b) anliegt und das Leuchtelement (1b) in der Innenröhre (28) verschiebbar ist.

2. Leuchte mit einem Leuchtelement (1b), das in einem Gehäuse (13) angeordnet ist, welches einen Reflektor (14) und ein Lichtaustrittsfenster (15) umfasst, und mit Einrichtungen zur Abführung von Wärme von dem Leuchtelement (1b), wobei das Leuchtelement (1b) in einer Hülle ( 7b) eingeschlossen ist, welche einen Einlass (11b) und einen Auslass (12) für ein an einer Innenwandfäche der Hülle (7b) strömendes Kühlmittel aufweist,
**dadurch gekennzeichnet,**
**dass** die Hülle ein Doppelrohr mit einer Außenröhre (7b) und einer Innenröhre (28) umfasst, wobei die Innenröhre (28) gegen das Leuchtelement (1b) anliegt und das Leuchtelement (1b) in der Innenröhre (28) verschiebbar ist.

3. Leuchte nach Anspruch 2,
**dadurch gekennzeichnet,**
**dass** das Leuchtelement (1b) und die Hülle (7b) in einer Baueinheit (21) zusammengefasst sind.

4. Leuchte nach Anspruch 2 oder 3,
**dadurch gekennzeichnet,**
**dass** das Leuchtelement (1b) länglich ist.

5. Leuchte nach einem der Ansprüche 2 bis 4,
**dadurch gekennzeichnet,**
**dass** das Leuchtelement (1b) an entgegengesetzten Enden jeweils einen Anschlusskontakt (3,4) aufweist.

6. Leuchte nach einem der Ansprüche 2 bis 5,
**dadurch gekennzeichnet,**
**dass** die Anschlusskontakte (3,4) des Leuchtelements (1b) gegen den durchströmten Innenraum (10b) der Hülle (7b) elektrisch isoliert sind.

7. Leuchte nach einem der Ansprüche 2 bis 6,
**dadurch gekennzeichnet,**
**dass** die Hülle (7b) Glas oder/und einen Kunststoff aufweist.

8. Leuchte nach einem der Ansprüche 2 bis 7,
**dadurch gekennzeichnet,**
**dass** der Ein- und Auslass (11b) im Innenraum des Gehäuses (13) angeordnet und Verbindungsleitungen (18) zu einem Einlass bzw. Auslass am Gehäuse (13) vorgesehen sind.

9. Leuchte nach einem der Ansprüche 2 bis 8,
**dadurch gekennzeichnet,**
**dass** der Einlass (11a) und der Auslass in Längsrichtung des Leuchtelements gesehen innerhalb der Kontur einer Öffnung (16) im Gehäuse (13) liegen.

10. Beleuchtungsanlage mit wenigstens einer Leuchte (20) nach einem der Ansprüche 2 bis 9.

11. Beleuchtungsanlage nach Anspruch 10,
**dadurch gekennzeichnet,**
**dass** die wenigstens eine Leuchte (20) in Strömungsverbindung mit einem Heizelement (22;22a) steht.

12. Beleuchtungsanlage nach Anspruch 10,
**dadurch gekennzeichnet,**
**dass** das Heizelement (22a) zur Beheizung einer Start- und Landebahn auf einem Flugplatz vorgesehen ist.

13. Beleuchtungsanlage nach einem der Ansprüche 10 bis 12,
**dadurch gekennzeichnet,**
**dass** das Heizelement (22a) zur Übertragung von Wärme an einen Wärmespeicher (23) vorgesehen ist.

14. Beleuchtungsanlage nach Anspruch 13,
**dadurch gekennzeichnet,**
**dass** thermoelektrische Elemente (24) zur Umwandlung in dem Wärmespeicher (23) gespeicherter Wärme in elektrische Energie vorgesehen sind.

## Claims

1. Modular unit comprising a light-emitting element (1b) and an envelope (7b), which has an inlet (11b) and an outlet (12) for a coolant slowing against an inner wall face of the envelope (7b) so as to dissipate heat away from the light-emitting element (1b), the envelope comprising a double tube with an outer tube (7b) and an inner tube (28), and the inner tube (28) bearing against the light-emitting element (1b), and the light-emitting element (1b) being movable in the inner tube (28).

2. Luminaire comprising a light-emitting element (1b), which is arranged in a housing (13), which comprises a reflector (14) and a light exit window (15), and comprising devices for dissipating heat away from the light-emitting element (1b), the light-emitting element (1b) being enclosed in an envelope (7b), which has an inlet (11b) and an outlet (12) for a coolant flowing against an inner wall face of the envelope (7b), **characterized in that** the envelope comprises a double tube with an outer tube (7b) and an inner tube (28), the inner tube (28) bearing against the light-emitting element (1b), and the light-emitting element (1b) being movable in the inner tube (28).

3. Luminaire according to Claim 2, **characterized in that** the light-emitting element (1b) and the envelope (7b) are combined in one modular unit (21).

4. Luminaire according to Claim 2 or 3, **characterized in that** the light-emitting element (16) is elongate.

5. Luminaire according to one of Claims 2 to 4, **characterized in that** the light-emitting element (1b) has a connection contact (3, 4) at each of its opposite ends.

6. Luminaire according to one of Claims 2 to 5, **characterized in that** the connection contacts (3, 4) of the light-emitting element (1b) are electrically insulated with respect to the interior (10b), through which a flow passes, of the envelope (7b).

7. Luminaire according to one of Claims 2 to 6, **characterized in that** the envelope (7b) consists of glass and/or a polymer.

8. Luminaire according to one of Claims 2 to 7, **characterized in that** the inlet and outlet (11b) are arranged in the interior of the housing (13) and connecting lines (18) to an inlet or outlet are provided on the housing (13).

9. Luminaire according to one of Claims 2 to 8, **characterized in that** the inlet (11a) and the outlet, when viewed in the longitudinal direction of the light-emitting element, lie within the contour of an opening (16) in the housing (13).

10. Lighting system comprising at least one luminaire (20) according to one of Claims 2 to 9.

11. Lighting system according to Claim 10, **characterized in that** the at least one luminaire (20) is flow-connected to a heating element (22; 22a).

12. Lighting system according to Claim 10, **characterized in that** the heating element (22a) is provided for heating a runaway on an airfield.

13. Lighting system according to one of Claims 10 to 12, **characterized in that** the heating element (22a) is provided for transmitting heat to a heat store (23).

14. Lighting system according to Claim 13, **characterized in that** thermoelectric elements (24) are provided for converting heat stored in the heat store (23) into electrical energy.

## Revendications

1. Unité structurelle comprenant un élément d'éclairage (1b) et une enveloppe (7b) qui comprend une entrée (11b) et une sortie (12) pour un milieu de refroidissement qui s'écoule le long d'une surface de paroi intérieure de l'enveloppe (7b) pour évacuer la chaleur de l'élément d'éclairage (1b), dans laquelle l'enveloppe inclut un tube double avec un tube extérieur (7b) et un tube intérieur (28), le tube intérieur (28) est appliqué contre l'élément d'éclairage (1b), et l'élément d'éclairage (1b) est déplaçable dans le tube intérieur (28).

2. Lampe comprenant un élément d'éclairage (1b) qui est agencé dans un boîtier (13), lequel inclut un réflecteur (14) et une fenêtre de sortie de lumière (15), et comprenant des moyens pour évacuer la chaleur de l'élément d'éclairage (1b), dans laquelle l'élément d'éclairage (1b) est enfermé dans enveloppé (7b), laquelle comprend une entrée (11b) et une sortie (12) pour un milieu de refroidissement qui s'écoule le long d'une surface de paroi intérieure de l'enveloppe (7b),
**caractérisée en ce que** l'enveloppe inclut un tube double avec un tube extérieur (7b) et un tube intérieur (28), le tube intérieur (28) est appliqué contre l'élément d'éclairage (1b), et l'élément d'éclairage (1b) est déplaçable dans le tube intérieur (28).

3. Lampe selon la revendication 2,
en ce que l'élément d'éclairage (1b) et l'enveloppe (7b) sont regroupés dans une unité structurelle (21).

4. Lampe selon la revendication 2 ou 3,
**caractérisée en ce que** l'élément d'éclairage (1b) est allongé.

5. Lampe selon l'une des revendications 2 à 4,
**caractérisée en ce que** l'élément d'éclairage (1b) comporte à ses extrémités opposées respectivement un contact de raccordement (3, 4).

6. Lampe selon l'une des revendications 2 à 5,
**caractérisée en ce que** les contacts de raccordement (3, 4) de l'élément d'éclairage (1b) sont électriquement isolés vis-à-vis de l'espace intérieur (10b), traversé par le milieu de refroidissement, de l'enveloppe (7b).

7. Lampe selon l'une des revendications 2 à 6,
**caractérisée en ce que** l'enveloppe (7b) comprend du verre et/ou une matière plastique.

8. Lampe selon l'une des revendications 2 à 7,
**caractérisée en ce que** l'entrée et la sortie (11b) sont agencées dans l'espace intérieur du boîtier (13), et **en ce qu'**il est prévu des conduites de liaison (18) vers une entrée et une sortie sur le boîtier (13).

9. Lampe selon l'une des revendications 2 à 8,
**caractérisée en ce que** l'entrée (11a) et la sortie sont, considéré en direction longitudinale de l'élément d'éclairage, situées à l'intérieur du contour d'une ouverture (16) dans le boîtier (13).

10. Installation d'éclairage comprenant au moins une lampe (20) selon l'une des revendications 2 à 9.

11. Installation d'éclairage selon la revendication 10,
**caractérisée en ce que** ladite au moins une lampe (20) est en liaison fluidique avec un élément chauffant (22 ; 22a).

12. Installation d'éclairage selon la revendication 10,
**caractérisée en ce que** l'élément chauffant (22a) est prévu pour le chauffage d'une piste de décollage/atterrissage sur un aérodrome.

13. Installation d'éclairage selon l'une des revendications 10 à 12,
**caractérisée en ce que** l'élément chauffant (22a) est prévu pour la transmission de chaleur à un accumulateur de chaleur (23).

14. Installation d'éclairage selon la revendication 13,
**caractérisés en ce qu'**il est prévu des éléments thermoélectriques (24) pour la conversion en énergie électrique de chaleur accumulée dans l'accumulateur de chaleur (23).
